# EUROPEAN PATENT APPLICATION

(11) **EP 1 511 095 A2**
(43) Date of publication of application: **02.03.2005**
(21) Application number: 04019149.6
(22) Date of filing: 12.08.2004
(51) Int. Cl.: H01L 51/20, H01L 27/00

(54) **Organic electroluminescent device and method of manufacturing the same**

(30) Priority: 19.08.2003 KR 2003057240; 22.04.2004 KR 2004027735
(71) Applicant: LG Electronics Inc., Seoul (KR)
(72) Inventor: Yoon, Myung-Hee, Daewon tenement house, Saha-gu 604-831 Busan (KR); Park, Hong-ki, Sasang-gu 617-807 Busan (KR); Kim, Woo-Chan, Gumi-shi 730-032 Kyongsangbuk-do (KR); Bae, Hyo-Dae, Dalseo-gu 704-130 Daegu (KR)
(74) Representative: Vetter, Ewald Otto

(57) **Abstract**

The present invention relates to an organic electroluminescent device and a method of manufacturing the same for enhancing brightness of the organic electroluminescent device. The organic electroluminescent device includes a panel protecting film (20) having the transmissibility of visible light of not less than about 50% and the transmissibility of ultraviolet rays of not more than about 5%, and attached onto the luminescent surface (1A) of a glass substrate (1). Here, it is desirable that the panel protecting film (20) has the transmissibility of visible light of about 70%.
A color compensating film attached on the luminescent surface which selectively filters light of a predetermined wavelength is also claimed.

## Description

### CROSS-REFERENCE TO RELATED APPLICATIONS

This application claims priority from Korean Patent Application No. 2003-57240, filed on August 19, 2003, and Korean Patent Application No. 2004-27735, filed on April 22, 2004, the contents of which are incorporated herein by reference in their entirety.

### BACKGROUND OF THE INVENTION

### 1. Field of the Invention

The present invention relates to an organic electroluminescent device and a method of manufacturing the same. Particularly, the present invention relates to an organic electroluminescent device and a method of manufacturing the same for enhancing brightness of the organic electroluminescent device.

### 2. Description of the Related Art

An organic electroluminescent device recombines holes and electrons injected through the anode and the cathode in an organic layer to generate light having particular wave length.

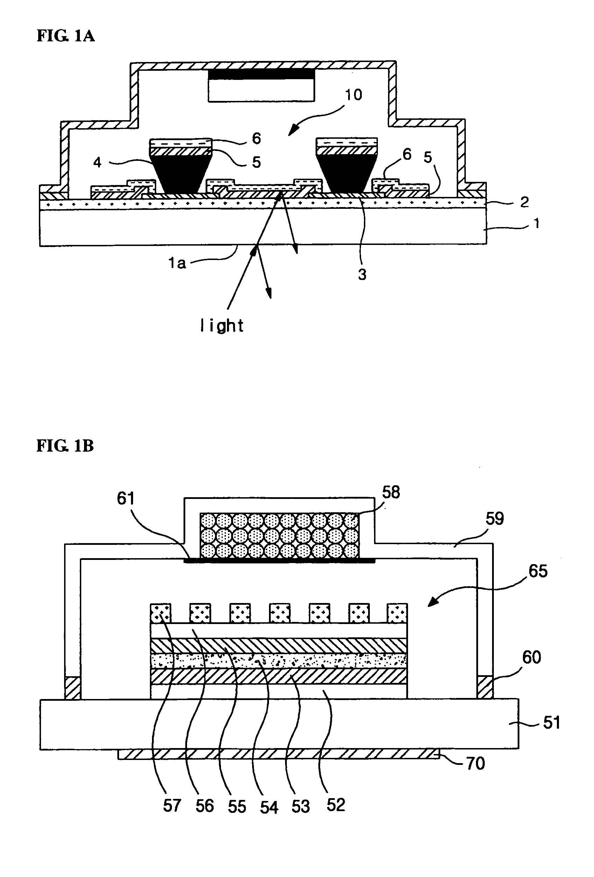

FIG 1A is a sectional view illustrating a conventional first organic electroluminescent device.

As shown in FIG 1A, the first organic electroluminescent device includes a glass substrate (1), an indium tin oxide film (hereinafter, referred to as "ITO film", 2) corresponding to the anode, an insulating film (3), a dam (4), an organic layer (5), and a metal line layer (6) corresponding to the cathode.

The light generated from the organic layer (5) is emitted through the glass substrate (1) to the outside. Also, a part of the generated light is reflected from a luminescent surface (1A), the reflected light is reflected from the metal line layer (6), and the reflected light from the metal line layer (6) is emitted through the glass substrate (1) to the outside.

In case of light incident through the glass substrate (1) from the outside (hereinafter, referred to as "outside light"), a part of the outside light is reflected from the glass substrate (1) as shown in FIG 1A. Additionally, the other part of the incident light is transmitted through the glass substrate (1) to the inside of the organic electroluminescent device, the transmitted outside light is reflected from the metal line layer (6), and then the reflected outside light is emitted through the glass substrate (1) to the outside. In this case, the outside light reflected from the glass substrate (1) and the metal line layer (6) reduces contrast of the light generated from the organic layer (5).

Thus, the first organic electroluminescent device attaching a polarizer film to its luminescent surface (1A) was developed in order to solve the reduction of the contrast of the light. However, in the polarizer film, the transmissibility of visible light is below about 50% when the polarization rate of the polarizer film is above about 99%. Hence, the loss of the brightness of the first organic electroluminescent device is augmented.

FIG. 1B is a sectional view illustrating a conventional second organic electroluminescent device.

As shown in FIG. 1B, a polarizer (70), for example, circular polarizer, is attached onto the luminescent surface of the second organic electroluminescent device. The polarizer (70) minimizes diffused reflection of the outside light to improve the contrast and to block ultraviolet rays, thereby protecting an organic electroluminescent array.

However, the polarizer (70) cuts off a part of the visible light as well as the outside light, and so the transmissibility of visible light generated from an emitting layer (55) is lowered less than about 50%. As a result, the brightness of the second organic electroluminescent device is decreased.

Moreover, the second organic electroluminescent device may generate light having undesired wave length when the holes and the electrons are recombined, to lower the color purity of the light generated from the emitting layer (55). Thus, a new invention (Application No. 2002-061727) provides a method of forming a color filter using red, green and blue resin in an organic electroluminescent array. However, its manufacturing process is complex, and the manufacturing cost is increased.

### SUMMARY OF THE INVENTION

It is a feature of the present invention to provide an organic electroluminescent device and a method of manufacturing the same by attaching a panel preventing film to the luminescent surface of a substrate, thereby reducing the brightness loss of the organic electroluminescent device, wherein the panel preventing film has excellent transmissibility of visible light.

It is another feature of the present invention to provide an organic electroluminescent device and a method of manufacturing the same for filtering light having particular wave length, thereby enhancing the color purity of light generated from an emitting layer.

It is still another feature of the present invention to provide an organic electroluminescent device and a method of manufacturing the same for enhancing the transmissibility of visible light to increase the brightness of the organic electroluminescent device.

An organic electroluminescent device according to one embodiment of the present invention comprises a panel preventing film having the transmissibility of visible light of not less than about 50% and the transmissibility of ultraviolet rays of not more than about 5%, and attached onto the luminescent surface of a glass substrate. Here, it is desirable that the panel preventing film has the transmissibility of visible light of about 70%. It is also desirable that the transmissibility of visible light is adjusted by transforming the panel protecting film material or changing its thickness. In addition, it is desirable that the panel preventing film is attached onto the glass substrate by using a gluing agent, wherein the gluing agent changes the transmissibility of visible light depending on the amount of its dyestuffs. The organic electroluminescent device further includes a reflection preventing film attached onto the panel preventing film or the glass substrate, and a static electricity preventing film attached onto the panel preventing film or the glass substrate.

An organic electroluminescent device according to another embodiment of the present invention comprises at least one color compensating film attached onto the luminescent surface of a substrate to filter selectively light having particular wave length. Here, the color compensating film is formed by coating a dyestuff or pigment for filtering light having predetermined wave length on a high molecular film. In addition, the organic electroluminescent device further includes a reflection preventing film formed on the color compensating film.

A method of manufacturing an organic electroluminescent device according to one embodiment of the present invention comprises forming at least one color compensating film which is attached onto the luminescent surface of a substrate and filters selectively light having predetermined wave length. Here, forming the color compensating film includes coating a dyestuff or pigment on a high molecular film. In addition, the method further includes forming the reflection preventing film on the color compensating film. Also, the color compensating film is attached to the luminescent surface by using laminating or gluing agent.

As described above, in the organic electroluminescent device of the present invention, the panel preventing film having high transmissibility of visible light is attached onto the luminescent surface of the glass substrate, and so the brightness loss of the organic electroluminescent device is reduced.

In addition, in the organic electroluminescent device of the present invention, the reflection preventing film is attached onto the glass substrate, and so the contrast is enhanced.

Additionally, in the organic electroluminescent device of the present invention, the static electricity preventing film is attached onto the substrate, and so damage to the elements of the device by static electricity is prevented.

Moreover, the organic electroluminescent device of the present invention includes at least one color compensating film with removing the conventional polarizer, thereby enhancing the color purity of the light generated from the emitting layer and enhancing the transmissibility of visible light.

### BRIEF DESCRIPTION OF THE DRAWINGS

The above and other features and advantages of the present invention will become readily apparent by reference to the following detailed description when considered in conjunction with the accompanying drawings wherein:
FIG 1A is a sectional view illustrating a conventional first organic electroluminescent device;
FIG 1B is a sectional view illustrating a conventional second organic electroluminescent device;
FIG 2 is a sectional view illustrating the luminescent surface of an organic electroluminescent device according to the first embodiment of the present invention;
FIG 3 and FIG 4 are sectional views illustrating the luminescent surface of an organic electroluminescent device according to the second embodiment of the present invention;
FIG 5 and FIG. 6 are sectional views illustrating the luminescent surface of an organic electroluminescent device according to the third embodiment of the present invention;
FIG 7 is a sectional view illustrating an organic electroluminescent device according to the fourth embodiment of the present invention;
FIG 8A and FIG 8B are plane views for describing the function of a color compensating film of FIG. 7;
FIG 9 is a sectional view illustrating the color compensating film of FIG 7; and
FIG 10 is a flowchart illustrating the process of manufacturing an organic electroluminescent device according to one embodiment of the present invention.

### DESCRIPTION OF EMBODIMENTS

Hereinafter, the preferred embodiments of the present invention will be explained in more detailed with reference to the accompanying drawings.

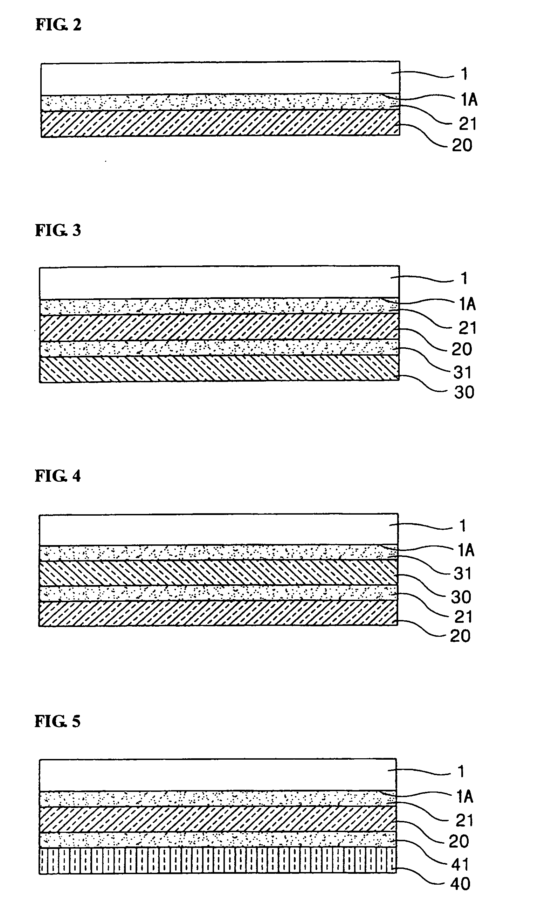

FIG 2 is a sectional view illustrating a luminescent surface of the organic electroluminescent device according to the first embodiment of the present invention.

In the following drawings, the same reference numbers will be used to refer to the same or functionally-same parts as those shown in the previous drawings.

In FIG 2, a panel protecting film (20) is attached onto the luminescent surface (1A) of a glass substrate (1). In particular, the panel protecting film (20) on which a gluing agent (21) is coated is attached onto the luminescent surface (1A).

It is desirable that the panel protecting film (20) has the transmissibility of visible light of above about 50% and the transmissibility of ultraviolet rays of less than about 5%.

Ultraviolet rays transmitted through the glass substrate (1) from the outside deteriorate the elements of the organic electroluminescent device. Therefore, it is desirable to select the panel protecting film (20) having the transmissibility of ultraviolet rays of less than about 5%.

The brightness loss of the panel protecting film (20) having the transmissibility of visible light of above about 50% is lower than that of the conventional polarizer film. In other words, light more than about 50% among the light generated from an emitting layer (5) is emitted through the glass substrate (1) to the outside, and thus the organic electroluminescent device of the present invention requires less consumption power than the conventional organic electroluminescent device.

However, the outside light reflected from the metal line layer (6) is augmented in accordance with increase of the transmissibility of visible light, and so the contrast of the organic electroluminescent device is lowered. Therefore, it is desirable to set the transmissibility of visible light to about 70% as the optimum point between the brightness and the contrast.

This transmissibility of visible light may be adjusted by changing material of the panel protecting film (20) or thickness thereof. Here, the transmissibility of visible light is reduced when the thickness of the panel protecting film (20) is augmented.

In addition, the transmissibility of visible light through the glass substrate (1) may be adjusted by changing the amount of dyestuff included in the gluing agent (21) used for attaching the panel protecting film (20) to the luminescent surface (1A).

FIG 3 is a sectional view illustrating the luminescent surface of the organic electroluminescent device according to the second embodiment of the present invention. Hereinafter, the preferred embodiments of the present invention will be explained in more detail with reference to the accompanying drawings.

A panel protecting film (20) on which a first gluing agent (21) is coated is attached to the luminescent surface (1A) of a glass substrate (1), and then a reflection protecting film (30) on which a second gluing agent (31) is coated is attached to the panel protecting film (20). Here, the second gluing agent (31) may be coated on the panel protecting film (20). Additionally, the reflection preventing film (30) may be attached onto the luminescent surface (1A) earlier than the panel protecting film (20) as shown in FIG 4.

The reflection protecting film (30) is formed with a plurality of layers including silicon dioxide (^{*SiO*₂}) or niobium oxide( ^{*Nb*₂*O*₅}), etc., and reduces the outside light reflected from the glass substrate (1) to not more than about 1 to 2%. As a result, the lowering of the contrast caused by the reflected light may be prevented.

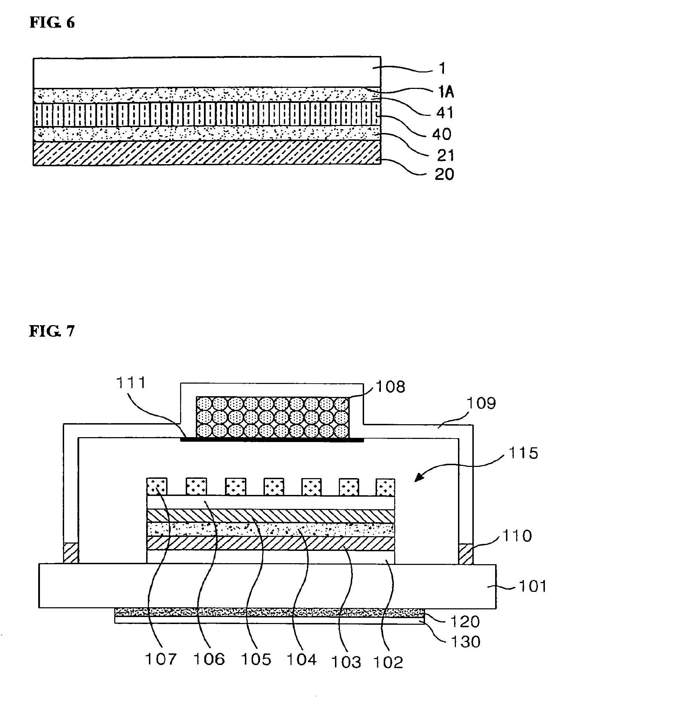

FIG 5 is a sectional view illustrating the luminescent surface of the organic electroluminescent device according to the third embodiment of the present invention.

In the following drawings, the same reference numbers will be used to refer to the same or functionally-same parts as those shown in the previous drawings.

As shown in FIG 5, a panel preventing film (20) on which a gluing agent (21) is coated is attached onto the luminescent surface (1A) of a glass substrate (1). Subsequently, a static electricity preventing film (40) on which a gluing agent (41) is coated is attached onto the panel preventing film (20). Here, the gluing agent (41) may be coated onto the panel preventing film (20).

The static electricity preventing film (40) may be attached onto the luminescent surface (1A) earlier than the panel preventing film (20) as shown in FIG 6.

The static electricity preventing film (40) has the surface resistance of about 1.0 x 10⁹ Ω, and prevents the elements of the organic electroluminescent device from being damaged by static electricity.

FIG 7 is a sectional view illustrating the organic electroluminescent device according to the fourth embodiment of the present invention.

In FIG 7, the organic electroluminescent device includes an anode (102) formed on a substrate (101), an insulating film (103), a hole relating layer (104), an emitting layer (EML, 105), and an electron relating layer (106), wherein the insulating film (103), the hole relating layer (104), the emitting layer (105), and the electron relating layer (106) are formed in sequence on the substrate (101) on which the anode (102) is formed. A cathode (107) is formed on the electron relating layer (106).

The anode (102) is formed by patterning ITO, IZO, ITZO and so on with using photolithography, etc. A photosensitive insulating material is coated by a spin-coating method, and then the coated photosensitive insulating material is patterned by photolithography, etc. so that the insulating film (103) is formed on the substrate (101) on which the anode (102) is formed. H ere, the insulating film (103) insulates electrically a plurality of pixels which include a hole relating layer, an emitting layer, and an electron relating layer.

The hole relating layer (104) includes a hole injection layer (HIL) and a hole transporting layer (HTL) which are formed in sequence on the anode (102).

The emitting layer (105) generates light having particular wave length.

The electron relating layer (106) includes an electron transporting layer (ETL) and an electron injection layer (EIL) which are formed in sequence on the emitting layer (105).

The hole relating layer (104), the emitting layer (105) and the electron relating layer (106) are formed by the vacuum evaporation method when they are formed with a compound having low molecular weight. Whereas, the hole relating layer (104), the emitting layer (105) and the electron relating layer (106) are formed by the spin-coating method or inkjet printing method, etc when they are formed with a high molecular compound.

The cathode (107) may be formed with silver (Ag), etc. having high reflectivity, but is generally formed with a metal such as aluminum (Al).

An organic electroluminescent array (115) is sealed by using cap (109) and a sealant (110). A getter (8) is formed at center of the cap (109), and absorbs water and oxygen. A semi-permeable film (111) is adhered to the cap (109) as shown in FIG 7, thereby fixing the getter (8) and permeating water, oxygen and so on.

At least one color compensating film (120) is attached onto the luminescent surface of the substrate (101) by using the laminating method and a gluing agent, etc. The color compensating film is formed by coating a dyestuff or pigment on a high molecular film such as polyethylene terephthalate (hereinafter, referred to as "PET"), etc., thereby filtering light having particular wave length, wherein the dyestuff or pigment may absorb or transmit light having particular wave length.

The color compensating film (120) transmits or absorbs light having desired wave length to enhance the color purity generated from the emitting layer (105).

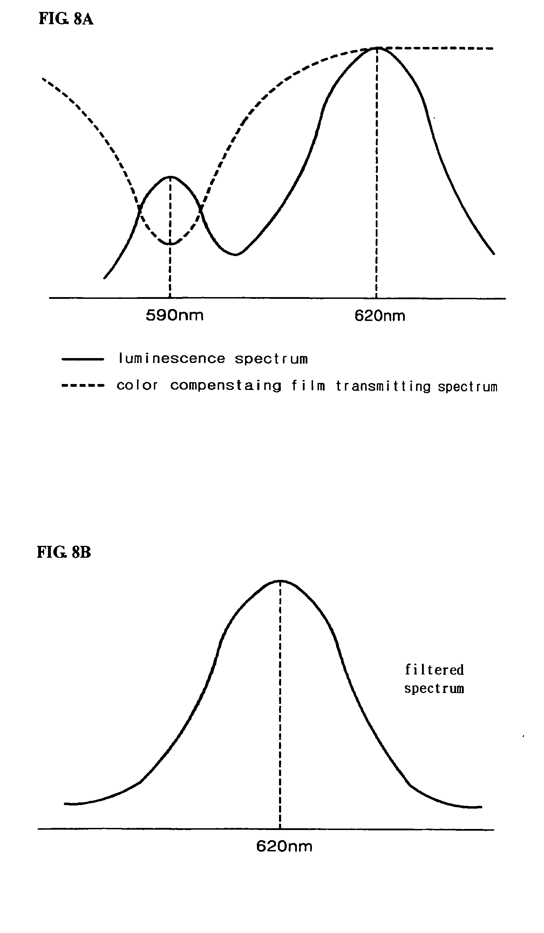

For example, when user wants to transmit light having a peak wave length of about 620□ and to remove light having a wave length of about 590□ as shown in FIG 8, the color compensating film (120) for absorbing light having a wave length of about 590□ and transmitting light having a wave length of about 620□ is attached onto the luminescent surface. In other words, the color compensating film (120) filters light having a wave length of about 590□ to enhance the color purity of light generated from the emitting layer (105).

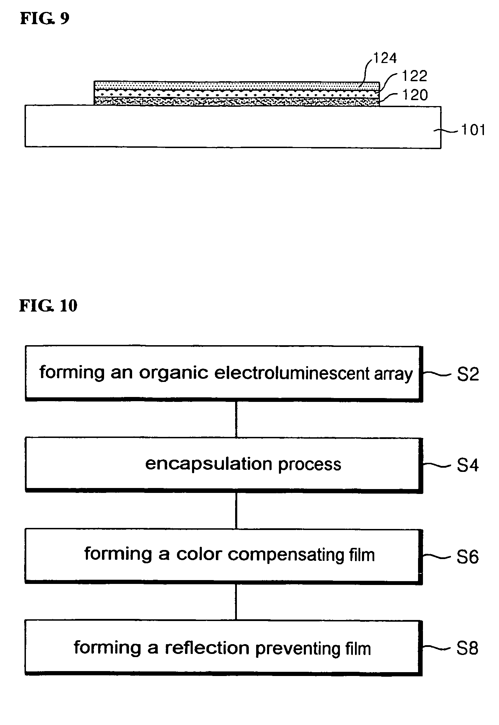

To enhance the color purity of light corresponding to red, blue and green, color compensating films (122 and 124) corresponding to blue and green may be deposited in sequence on a color compensating film (120) corresponding to red as shown in FIG 9. Some dyestuffs and pigment disclosed in the conventional art may be used for the color compensating film (124).

The color compensating film (120) is directly attached onto the luminescent surface of the substrate (101), thereby filtering more efficiently light having particular wave length when light is generated from the emitting layer (105). In addition, the organic electroluminescent device includes the color compensating film (120) without a conventional polarizer to enhance the transmissibility of visible light when light is generated from the emitting layer (105). As a result, the brightness of the organic electroluminescent device is enhanced, and so the consumption power thereof is reduced.

The color compensating film (120) uses a high molecular film for cutting off ultraviolet rays, or a reflection preventing film (130) is formed on the color compensating film (120). Therefore, the lowering of the contrast caused by the reflected light is prevented. Here, any known film for preventing the outside light such as ultraviolet rays, for example anti-glare film or anti-reflection film, may be used as the reflection preventing film (130).

In the organic electroluminescent device according to another embodiment of the invention, a black matrix layer disclosed in Korean Laid Open Publication No. 1999-57105 is used instead of the insulating film (103), or the insulating film (103) includes a material having a black material. Particularly, the compound of at least one of organic material, non-organic material, or high molecular with a black material, for example black carbon, may be used instead of the insulating film (103), or the insulating film (103) may include a material having a black material. As a result, the lowering of the contrast caused by the reflected light is prevented.

FIG. 10 is a flowchart illustrating a process of manufacturing the organic electroluminescent device according to one embodiment of the present invention.

In step S2, the organic electroluminescent array (115) is formed on the substrate with including the anode, the insulating film, the organic layer, and the cathode in sequence. Here, the insulating film (103) may include a black material, for example black carbon, or a black matrix may be formed on the substrate (101) instead of the insulating film (103).

In step S4, an encapsulation process for packaging the organic electroluminescent array (115) is performed, and so the substrate (101) and the cap (109) are attached by the sealant (110).

In step S6, at least one color compensating film (120) formed by an extra-process is attached onto the luminescent surface of the substrate (101) using a gluing agent or laminating. Here, the color compensating film (120) is formed by coating a dyestuff or pigment for absorbing or transmitting light having particular wave length on a high molecular film, for example PET, to filter the light.

In step S8, the reflection preventing film (130) is formed on the color compensating film (120).

The organic electroluminescent device includes the color compensating film (120) instead of the conventional polarizer. Here, the color compensating film (120) filters light having particular wave length, thereby enhancing the color purity of light.

Additionally, the transmissibility of visible light is enhanced because the organic electroluminescent device of the present invention uses the color compensating film (120) with removing the conventional polarizer, and so the brightness of the organic electroluminescent device of the present invention is enhanced.

From the preferred embodiments for the present invention, i t is noted that modifications and variations can be made by a person skilled in the art in light of the above teachings. Therefore, it should be understood that changes may be made for a particular embodiment of the present invention within the scope and spirit of the present invention outlined by the appended claims.

The claims refer to examples of preferred embodiments of the invention. However, the invention also refers to the use of any single feature and subcombination of features which are disclosed in the claims, the description and/or the drawings.

## Claims

1. An organic electroluminescent device comprising:
a panel preventing film having the transmissibility of visible light of not less than about 50% and the transmissibility of ultraviolet rays of not more than about 5%, and attached onto the luminescent surface of a glass substrate.

2. The organic electroluminescent device of claim 1, wherein the panel preventing film has the transmissibility of visible light of about 70%.

3. The organic electroluminescent device of claim 1, further including a reflection preventing film attached onto the panel preventing film or the glass substrate.

4. The organic electroluminescent device of claim 1, further including a static electricity preventing film attached onto the panel preventing film or the glass substrate.

5. An organic electroluminescent device comprising:
at least one color compensating film attached onto the luminescent surface of a substrate to filter selectively light having particular wave length.

6. The organic electroluminescent device of claim 5, wherein the color compensating film is formed by coating a dyestuff or pigment for filtering light having a predetermined wave length on a high molecular film.

7. The organic electroluminescent device of claim 5, further including a reflection preventing film formed on the color compensating film.

8. A method of manufacturing an organic electroluminescent device comprising:
forming at least one color compensating film which is attached onto the luminescent surface of a substrate and filters selectively light having predetermined wave length.

9. The method of claim 8, wherein forming of the color compensating film includes coating a dyestuff or pigment on a high molecular film.

10. The method of claim 8, further including:
forming a reflection preventing film on the color compensating film.

11. The method of claim 8, wherein the color compensating film is attached onto the luminescent surface by using laminating or a gluing agent.
